# EUROPEAN PATENT APPLICATION

(11) **EP 4 293 421 A1**
(43) Date of publication of application: **20.12.2023**
(21) Application number: 22752702.5
(22) Date of filing: 04.02.2022
(51) Int. Cl.: G03F 1/24, G03F 1/26, G03F 1/54

(54) **REFLECTIVE PHOTOMASK BLANK AND REFLECTIVE PHOTOMASK**

(30) Priority: 12.02.2021 JP 2021021295
(71) Applicant: Toppan Photomask Co., Ltd., Tokyo 108-0023 (JP)
(72) Inventor: GORAI, Ryohei, Tokyo 110-0016 (JP); GODA, Ayumi, Tokyo 110-0016 (JP)
(74) Representative: Hoffmann Eitle
(86) International application number: PCT/JP2022/004498
(87) International publication number: WO 2022/172878

(57) **Abstract**

There are provided a reflective photomask and a reflective photomask blank having high transfer performance while suppressing the influence of the shadowing effect. A reflective photomask blank (100) according to this embodiment includes: a substrate (11); a reflective part (17) formed on the substrate (11) and configured to reflect an incident light; and a low reflective part (18) formed on the reflective part (17) and configured to absorb an incident light, in which the low reflective part (18) is a multi-layer structural body having at least two or more layers including an absorption layer (14) and a phase shift layer (15), the absorption layer (14) and the phase shift layer (15) are deposited in this order on the reflective part (17), the optical constant to a wavelength of 13.5 nm of a material constituting the absorption layer (14) satisfies an extinction coefficient k > 0.04, and the optical constant to the wavelength of 13.5 nm of a material constituting the phase shift layer (15) satisfies a refractive index n < 0.94 and the extinction coefficient k < 0.02.

## Description

### Technical Field

The present disclosure relates to a reflective photomask blank and a reflective photomask.

### Background Art

In a manufacturing process of semiconductor devices, a demand for miniaturization by a photolithography technology has increased with the miniaturization of the semiconductor devices. The minimum resolution dimension of a transfer pattern in the photolithography largely depends on the wavelength of an exposure light source, and the minimum resolution dimension can be made smaller as the wavelength is shorter. Therefore, as the exposure light source, the application of an EUV (Extreme Ultra Violet) having a wavelength of 13.5 nm, in place of a conventional ArF excimer laser light having a wavelength of 193 nm, has been started.

The light in the EUV region is absorbed by most materials at a high ratio, and therefore a reflective photomask (EUV mask) is used as a photomask for EUV exposure (see PTL 1, for example). PTL 1 discloses an EUV photomask obtained by forming a reflective layer containing a multi-layer film in which molybdenum (Mo) layers and silicon (Si) layers are alternately deposited on a glass substrate, forming a light absorption layer containing tantalum (Ta) as the main ingredient on the reflective layer, and forming a pattern on the light absorption layer.

Further, in the EUV lithography, a dioptric system utilizing light transmission cannot be used as described above, and therefore an optical system member of an exposure machine is not a lens but a reflective type (mirror). This poses a problem that an incident light and a reflected light on the EUV mask cannot be coaxially designed. Thus, in the EUV lithography, a technique is commonly employed which includes making the EUV light incident by tilting the optical axis by 6° from the vertical direction of the EUV mask and guiding a reflected light reflected at an angle of -6° to a semiconductor substrate.

As described above, the optical axis is tilted through the mirror in the EUV lithography, and therefore a problem referred to as a shadowing effect occurs, the shadowing effect in which the EUV light incident on the EUV mask creates a shadow of a mask pattern (patterned light absorption layer) of the EUV mask.

In a current EUV mask blank, a film containing tantalum (Ta) as the main ingredient and having a film thickness of 60 to 90 nm is used as the light absorption layer. When the exposure of pattern transfer is performed with an EUV mask produced using the EUV mask blank, there is a risk of causing a reduction in the contrast in an edge part to be shadowed by the mask pattern, depending on the relationship between the incident direction and the orientation of the mask pattern. Consequently, problems, such as an increase in line edge roughness of the transfer pattern on the semiconductor substrate and an inability to form a line width with a target dimension, occur, deteriorating the transfer performance in some cases.

Thus, a reflective mask blank has been studied in which, for the absorption layer, a material is changed from tantalum (Ta) to a material having high absorptivity (extinction coefficient) to the EUV light or a material having high absorptivity is added to tantalum (Ta). For example, PTL 2 describes a reflective mask blank in which an absorption layer contains a material containing 50 at% or more of Ta as the main ingredient and further containing at least one kind of element selected from Te, Sb, Pt, I, Bi, Ir, Os, W, Re, Sn, In, Po, Fe, Au, Hg, Ga and Al.

Recently, with further miniaturization, the use of a reflective mask blank using a phase shift effect has also been studied. The phase shift effect refers to an effect of adjusting the phase of a transmitted light passing through a phase shift part adjacent to an opening part to be inverted from the phase of a transmitted light passing through the opening part, thereby weakening the light intensity of a part where the transmitted lights interfere with each other, resulting in an improved transfer contrast and an improved resolution in a transfer pattern. Therefore, a further improvement of transferability can be expected by the use of the phase shift effect also for the reflective mask blank.

For example, a reflective mask blank using the phase shift effect described in PTL 3 is limited in the film thickness or combinations of material compositions of a phase shift layer from a phase difference improving the reflectance and the contrast. It is described in PTL 3 that this reduces the film thickness of the phase shift layer to 60 nm or less, and achieves the phase shift effect while reducing the shadowing effect. However, PTL 3 derives the film thickness from the material and the targeted reflectance/phase difference, and claims that the film thickness is smaller than before, but does not mention the actual transferability. When the phase shift film is formed of a material having high EUV absorption, such as Ni or Co, the film, even when it is thinner than a conventional film, strongly interferes with an EUV light obliquely made incident, so that the transferability is not improved in some cases.

### Citation List

### Patent Literature

PTL 1: JP 2011-176162 A
PTL 2: JP 2007-273678 A
PTL 3: WO 2019/225737

### Summary of Invention

### Technical Problem

It is an object of the present invention to provide a reflective photomask blank and a reflective photomask having high transfer performance by maximizing the use of the phase shift effect and suppressing or reducing the influence of the shadowing effect.

### Solution to Problem

To solve the above-described problems, a reflective photomask blank according to one aspect of the present disclosure is a reflective photomask blank for producing a reflective photomask for pattern transfer using an extreme ultraviolet light as a light source, and includes: a substrate; a reflective part formed on the substrate and configured to reflect an incident light; and a low reflective part formed on the reflective part and configured to absorb an incident light, in which the low reflective part is a multi-layer structural body having at least two or more layers including an absorption layer and a phase shift layer, the absorption layer and the phase shift layer are deposited in this order on the reflective part, the optical constant to a wavelength of 13.5 nm of a material constituting the absorption layer satisfies an extinction coefficient k > 0.04, and the optical constant to the wavelength of 13.5 nm of a material constituting the phase shift layer satisfies a refractive index n < 0.94 and the extinction coefficient k < 0.02.

The absorption layer in the reflective photomask blank according to one aspect of the present disclosure preferably contains a total of 50 at% or more of at least one kind of atoms or molecules selected from the group consisting of tellurium (Te), cobalt (Co), nickel (Ni), platinum (Pt), silver (Ag), tin (Sn), indium (In), copper (Cu), zinc (Zn), and bismuth (Bi), and oxides, nitrides, and oxynitrides thereof.

The phase shift layer in the reflective photomask blank according to one aspect of the present disclosure preferably contains a total of 50 at% or more of at least one kind of atoms or molecules selected from the group consisting of molybdenum (Mo), ruthenium (Ru), and niobium (Nb), and oxides, nitrides, and oxynitrides thereof.

The low reflective part containing the absorption layer and the phase shift layer in the reflective photomask blank according to one aspect of the present disclosure preferably has a phase difference of 160 to 200° to the reflective part and a reflectance of 1% to 40% according to a film thickness ratio of the absorption layer and the phase shift layer.

A reflective photomask according to one aspect of the present disclosure is a reflective photomask for pattern transfer using an extreme ultraviolet light as a light source, and includes: a substrate; a reflective part formed on the substrate and configured to reflect an incident light; and a low reflective part formed on the reflective part and configured to absorb an incident light, in which the low reflective part is a multi-layer structural body having at least two or more layers including an absorption layer and a phase shift layer, the absorption layer and the phase shift layer are deposited in this order on the reflective part, the optical constant to a wavelength of 13.5 nm of a material constituting the absorption layer satisfies an extinction coefficient k > 0.04, and the optical constant to the wavelength of 13.5 nm of a material constituting the phase shift layer satisfies the refractive index n < 0.94 and the extinction coefficient k < 0.02.

### Advantageous Effects of Invention

The reflective photomask and the reflective photomask blank for producing the same according to one aspect of the present disclosure can provide a reflective photomask and a reflective photomask blank having high transfer performance while suppressing the influence of the shadowing effect.

### Brief Description of Drawings

FIG. 1 is a cross-sectional view schematically illustrating one configuration example of a reflective photomask blank according to this embodiment;
FIG. 2 is a cross-sectional view schematically illustrating one configuration example of a reflective photomask according to this embodiment;
FIG. 3 is a graph showing the optical constant of each metal at the wavelength of an EUV light;
FIG. 4 is a schematic cross-sectional view illustrating a manufacturing process of the reflective photomask according to this embodiment;
FIG. 5 is a schematic cross-sectional view illustrating a manufacturing process of the reflective photomask according to this embodiment;
FIG. 6 is a schematic cross-sectional view illustrating a manufacturing process of the reflective photomask according to this embodiment;
FIG. 7 is a schematic cross-sectional view illustrating a manufacturing process of the reflective photomask according to this embodiment;
FIG. 8 is a schematic cross-sectional view illustrating a manufacturing process of the reflective photomask according to this embodiment; and
FIG. 9 is a schematic plan view illustrating a design pattern of a reflective photomask according to Examples of the present invention.

### Description of Embodiments

One embodiment of the present disclosure will now be described with reference to the drawings.

Herein, the configurations illustrated in the drawings are schematic, and the relationship between the thickness and the plane dimension, the thickness ratio of each layer, and the like are different from the actual relationship, ratio, and the like. The embodiment described below exemplifies configurations for embodying the technical idea of the present disclosure. In the technical idea of the present disclosure, materials, shapes, structures, and the like of constituent components are not limited to the materials, shapes, structures, and the like described below. The technical idea of the present disclosure can be variously altered within the technical range defined by Claims.

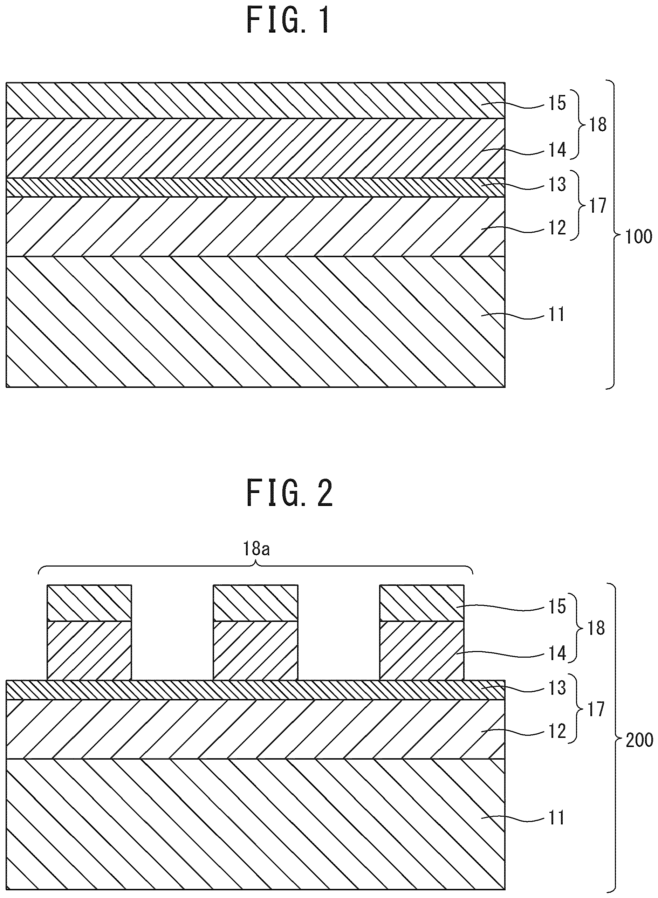

FIG. 1 is a schematic cross-sectional view illustrating a reflective photomask blank 100 according to an embodiment of the present invention. FIG. 2 is a schematic cross-sectional view illustrating a reflective photomask 200 according to an embodiment of the present invention. The reflective photomask 200 according to the embodiment of the present invention illustrated in FIG. 2 is formed by patterning a low reflective part 18 of the reflective photomask blank 100 according to the embodiment of the present invention illustrated in FIG. 1.

### (Configuration of reflective photomask blank)

The basic configuration of the reflective photomask blank according to the embodiment of the present disclosure is described using FIG. 1.

As illustrated in FIG. 1, the reflective photomask blank 100 according to one embodiment of the present disclosure includes a substrate 11, a reflective part 17 formed on the substrate 11, and the low reflective part 18 formed on the reflective part 17. The reflective photomask blank 100 further includes a multi-layer reflective film 12 and a capping layer 13 in the reflective part 17 and includes an absorption layer 14 and a phase shift layer 15 in the low reflective part 18. More specifically, the reflective photomask 200 has the multi-layer reflective film 12, the capping layer 13, the absorption layer 14, and the phase shift layer 15 deposited in this order on one surface side of the substrate 11. Hereinafter, each layer is described in detail.

### (Substrate)

The substrate 11 is a layer serving as a base of the reflective photomask blank 100. For the substrate 11 according to the embodiment of the present invention, a flat Si substrate, synthetic quartz substrate, or the like is usable. Further, a low thermal expansion glass to which titanium is added is usable for the substrate 11. However, the present invention is not limited to the above, and any material having a small thermal expansion coefficient may be acceptable.

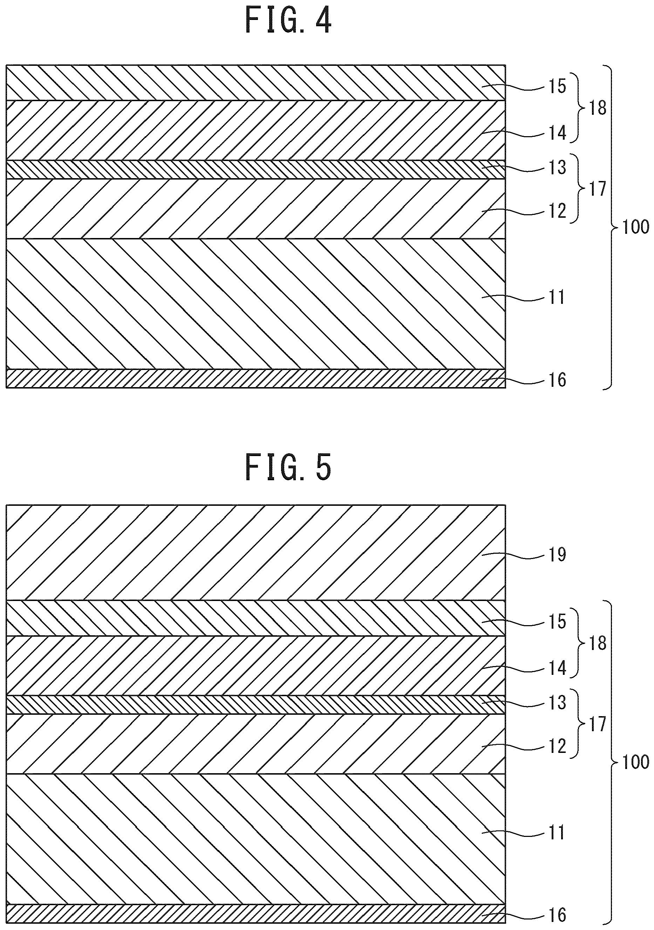

As illustrated in FIG. 4, a back surface conductive film 16 can be formed on the surface on which the multi-layer reflective film 12 is not formed of the substrate 11. The back surface conductive film 16 is a film for fixing the reflective photomask blank 100 utilizing the principle of an electrostatic chuck when the reflective photomask blank 100 is installed in an exposure machine.

### (Reflective part)

The reflective part 17 is formed on the substrate 11 and is provided to reflect a light incident on the reflective photomask blank 100. The reflective part 17 includes the multi-layer reflective film 12 and the capping layer 13.

### (Multi-layer reflective film)

The multi-layer reflective film 12 is a layer formed on the substrate 11 and is a layer provided to reflect an EUV light (extreme ultraviolet light) which is an exposure light in the reflective photomask blank 100.

The multi-layer reflective film 12 contains a plurality of reflective films containing a combination of materials having greatly different refractive indices to the EUV light. For example, the multi-layer reflective film 12 can be formed by repeatedly depositing a layer containing a combination of Mo (molybdenum) and Si (silicon) or Mo (molybdenum) and Be (beryllium) by about 40 cycles.

### (Capping layer)

The capping layer 13 is a layer formed on the multi-layer reflective film 12 and is a layer functioning as an etching stopper to prevent damage to the multi-layer reflective film 12 when an absorption layer pattern is dry etched. The capping layer 13 according to the embodiment of the present invention is formed of a material resistant to dry etching performed in pattern formation of the absorption layer 14. For example, ruthenium (Ru) is generally applied to the capping layer 13. The capping layer 13 may not be provided depending on materials of the multi-layer reflective film 12 and etching conditions.

### (Low reflective part)

The low reflective part 18 is a layer formed on the reflective part 17 and provided to absorb an EUV light, which is an exposure light, in the reflective photomask blank 100. The low reflective part 18 includes the absorption layer 14 and the phase shift layer 15. The low reflective part 18 contains at least two or more layers, one of which is the absorption layer 14, and the phase shift layer 15 is provided on the absorption layer 14.

### (Absorption layer)

The absorption layer 14 is a layer formed on the capping layer 13 and is a layer containing at least one or more layers. The absorption layer 14 is a layer forming the absorption layer pattern (transfer pattern) which is a fine pattern for transfer.

As illustrated in FIG. 2, an absorption pattern (absorption layer pattern) of the reflective photomask 200 is formed by removing a part of the absorption layer 14 of the reflective photomask blank, i.e., patterning the absorption layer 14. In the EUV lithography, the EUV light is obliquely incident and reflected on the reflective part 17, but the transfer performance onto a wafer (semiconductor substrate) sometimes deteriorates due to a shadowing effect in which a low reflective part pattern 18a interferes with an optical path. This deterioration of the transfer performance is reduced by reducing the thickness of the absorption layer 14 absorbing the EUV light.

To reduce the thickness of the low reflective part 18, a material having higher absorptivity to the EUV light than that of a conventional material, i.e., a material having a high extinction coefficient k to a wavelength of 13.5 nm, is preferably applied to the low reflective part 18.

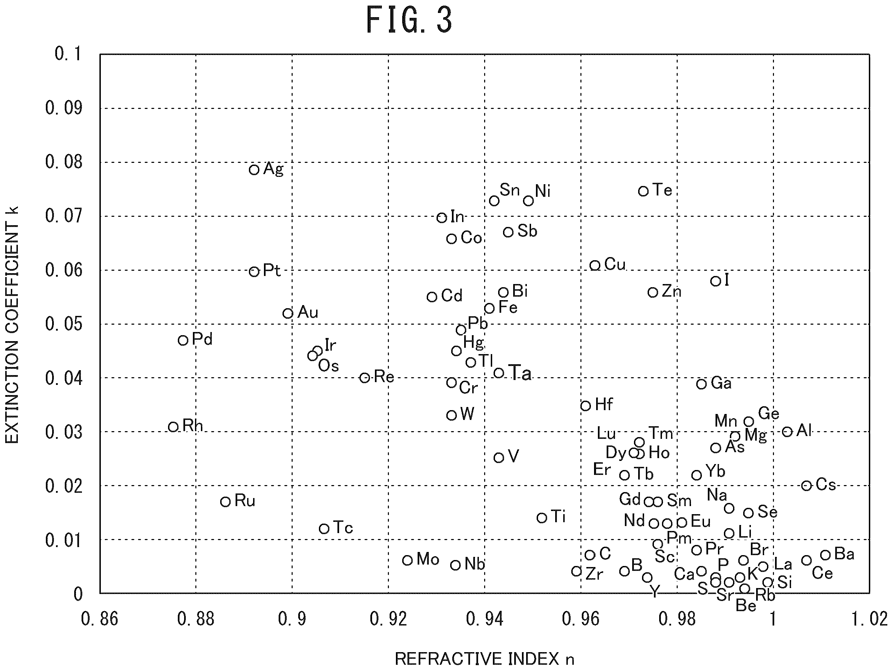

FIG. 3 is a graph showing the optical constant to the wavelength of 13.5 nm of the EUV light of each metal material. The horizontal axis of FIG. 3 represents the refractive index n and the vertical axis represents the extinction coefficient k. As illustrated in FIG. 3, the extinction coefficient k of tantalum (Ta), which is a main material of the conventional absorption layer 14, is 0.041. When the main material of the absorption layer 14 is a compound material having the extinction coefficient k larger than that of tantalum (Ta), the thickness of the absorption layer 14 can be further reduced as compared with conventional compound materials, and the shadowing effect can be reduced. When the extinction coefficient k is 0.06 or more, the thickness of the absorption layer 14 can be sufficiently reduced, and the shadowing effect can be reduced.

Examples of materials having the extinction coefficient k of 0.041 or more described above include silver (Ag), platinum (Pt), indium (In), cobalt (Co), tin (Sn), nickel (Ni), tellurium (Te), copper (Cu), zinc (Zn), and bismuth (Bi) as illustrated in FIG. 3. Therefore, materials of the absorption layer 14 preferably contain a total of 50 at% or more of at least one kind of element selected from the group consisting of tellurium (Te), cobalt (Co), nickel (Ni), platinum (Pt), silver (Ag), tin (Sn), indium (In), copper (Cu), zinc (Zn), and bismuth (Bi), and oxides, nitrides, and oxynitrides thereof.

In the reflective photomask blank, the absorption layer 14 needs to be easily processable for patterning. Among the materials above, tin oxide is known to be dry-etchable using a chlorine-based gas. It is also known that a tin (Sn) simple substance has a low melting point and poor thermal stability, but its melting point increases when made into tin oxide. Therefore, the absorption layer 14 preferably contains tin (Sn) and oxygen (O) in this embodiment.

The reflective photomask is exposed to a hydrogen radical environment, and therefore the photomask cannot withstand long-term use unless the materials of the absorption layer 14 are absorption materials having high hydrogen radical resistance. A material having a film reduction rate of 0.1 nm/s or less under a hydrogen radical environment having a power of 1 kW and a hydrogen pressure of 0.36 mbar or less using a microwave plasma is used as a material having high hydrogen radical resistance. In the materials of the absorption layer 14, the tin (Sn) simple substance has low resistance to hydrogen radicals, but the addition of oxygen increases the hydrogen radical resistance. Specifically, the hydrogen radical resistance has been confirmed in materials in which the atomic number ratio of tin (Sn) and oxygen (O) exceeds 1:2. When the atomic number ratio of tin (Sn) and oxygen (O) is 1:2 or less, all of the tin bonds do not form tin oxide (SnO₂), and therefore the atomic number ratio exceeding 1:2 is required for making a film entirely formed of tin oxide (SnO₂). The atomic number ratio above is the result of measuring a material formed into a film to have a film thickness of 1 µm by EDX (energy dispersive X-ray analysis).

The materials containing tin (Sn) and oxygen (O) for forming the absorption layer 14 preferably contain oxygen in a larger amount than the amount of stoichiometric tin oxide (SnO₂). More specifically, the atomic number ratio of tin (Sn) and oxygen (O) in the materials of the absorption layer preferably exceeds 1:2. Further, the atomic number ratio of tin (Sn) and oxygen (O) is preferably smaller than 1:4 and preferably 1:3.5 or less. When the atomic number ratio of tin (Sn) and oxygen (O) is 1:3.5 or less, the decrease in absorptivity of the absorption layer 14 can be suppressed.

The materials of the absorption layer 14 preferably contain a total of 50 at% or more of tin (Sn) and oxygen (O). This is because, when the absorption layer contains ingredients other than tin (Sn) and oxygen (O), there is a possibility that both the EUV light absorptivity and the hydrogen radical resistance decrease, but, when the ingredients are contained in a proportion of less than 50 at%, both the EUV light absorptivity and the hydrogen radical resistance decrease very slightly, and the performance as the absorption layer 14 of the EUV mask hardly decreases.

In the absorption layer 14, as materials other than tin (Sn) and oxygen (O), tantalum (Ta), platinum (Pt), tellurium (Te), zirconium (Zr), hafnium (Hf), titanium (Ti), tungsten (W), silicon (Si), chromium (Cr), indium (In), palladium (Pd), nickel (Ni), fluorine (F), nitrogen (N), carbon (C), and hydrogen (H) may be mixed. The mixing of indium (In), for example, makes it possible to impart conductivity to the film while the high absorptivity is ensured. This makes it possible to enhance the inspection performance in mask pattern inspection using a deep ultraviolet (DUV) light having a wavelength of 190 to 260 nm. Alternatively, the mixing of nitrogen (N) or hafnium (Hf) makes it possible to make the film quality more amorphous for an improvement of the roughness, the in-plane dimensional uniformity of the absorption layer pattern after dry etching or the in-plane uniformity of a transferred image.

### (Phase shift layer)

The phase shift layer 15 is a layer formed on the absorption layer 14 and is a layer provided to change the phase of an incident light to exhibit a phase shift effect and obtain high resolution. The phase shift effect refers to an effect of adjusting the phase of a transmitted light passing through the phase shift layer 15 to be inverted from the phase of a transmitted light not passing through the phase shift layer 15, thereby weakening the light intensity of a part where the transmitted lights interfere with each other, resulting in an improved transfer contrast and an improved resolution in a transfer pattern.

For the phase shift layer 15, a part of the phase shift layer 15 is removed as with the absorption layer 14, thereby forming a phase shift pattern (phase shift layer pattern).

In this embodiment, the absorption layer 14 and the phase shift layer 15 are deposited in this order on the reflective part in the reflective photomask. The formation of the phase shift layer 15 having low absorption on an upper layer of the absorption layer 14 minimizes the shadowing effect, expresses the phase shift effect, and obtains high resolution.

In the reflective photomask, higher resolution is obtained by the phase shift effect by adjusting the film thickness of each layer such that a phase difference between a reflected light from a reflective part and a reflected light from the low reflective part is 170 to 190°. The phase shift layer 15 preferably has a refractive index n < 1 and more preferably has the refractive index n < 0.94. When the refractive index n of the phase shift layer 15 is smaller than 1, which is the refractive index in vacuum, the adjustment of the phase difference by the film thickness is facilitated. When the film thickness of the phase shift layer 15 is large, the film thickness of the entire low reflective part 18 is large, deteriorating the resolution due to the shadowing effect.

A material of the phase shift layer 15 is preferably a material which can be etched using a fluorine-based gas or a chlorine-based gas because patterning processing is performed in the phase shift layer 15. The material of the phase shift layer 15 is preferably a material having the extinction coefficient k < 0.02 not to affect the shadowing effect. Specifically, the material of the phase shift layer 15 preferably contains at least one kind of element of molybdenum (Mo), ruthenium (Ru), and niobium (Nb), and oxides, nitrides, and oxynitrides thereof. Not to reduce the etching rate, the phase shift layer 15 desirably contains a material containing at least 50% or more of the materials above.

When the absorption layer 14 contains tin or indium (In) that can be etched using a chlorine gas, molybdenum (Mo) that can be etched similarly using a chlorine-based gas can be suitably selected also in the phase shift layer 15. In this case, the low reflective part can be etched in a single process, and therefore the simplification of the process or a reduction in contamination can be expected.

The low reflective part 18 including the absorption layer 14 and the phase shift layer 15 described above preferably has a phase difference of 160 to 200° to the reflective part 17 and a reflectance of 1% to 40% according to a film thickness ratio of the absorption layer 14 and the phase shift layer 15. The low reflective part 18 more preferably has a phase difference 170 to 190° to the reflective part 17 and a reflectance of 10% to 40% according to the film thickness ratio of the absorption layer 14 and the phase shift layer 15.

### (Method for manufacturing reflective photomask)

Next, a method for manufacturing a reflective photomask is described using FIGS. 4 to 8.

As illustrated in FIG. 4, a positive chemically amplified resist (SEBP9012: manufactured by Shin-Etsu Chemical Co., Ltd.) was formed by spin coating to have a film thickness of 120 nm on the low reflective part 18 provided in the reflective photomask blank 100. Thereafter, the resist was baked at 110°C for 10 min to form a resist film 19 as illustrated in FIG. 5.

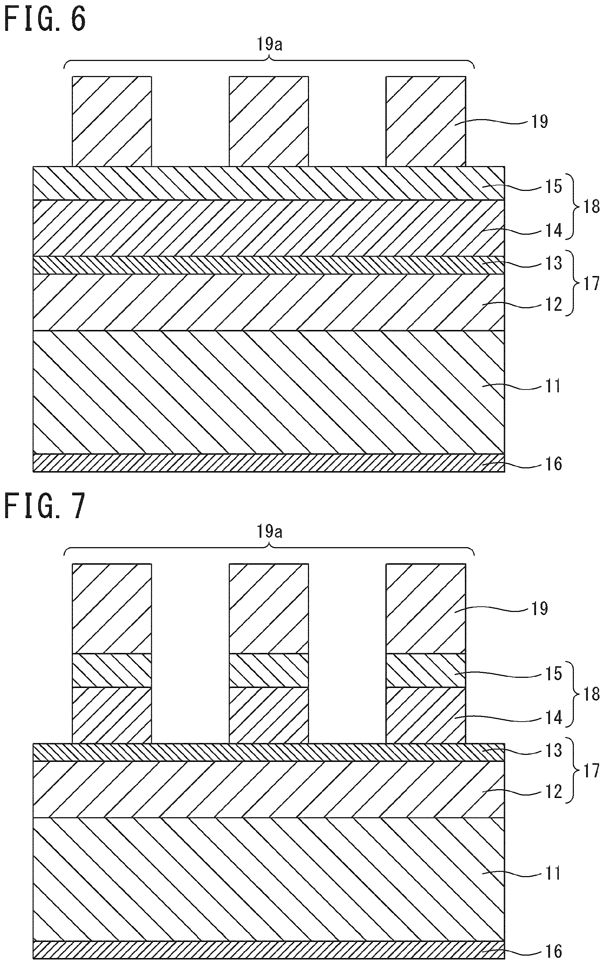

Next, a predetermined pattern was drawn on the resist film 19 formed of the positive chemically amplified resist by an electron beam lithography machine (JBX3030: manufactured by JEOL). Thereafter, baking treatment was performed at 110°C for 10 minutes, followed by spray development (SFG3000: manufactured by Sigma Meltec). Thus, a resist pattern 19a was formed as illustrated in FIG. 6.

Next, as illustrated in FIG. 7, the phase shift layer 15 was patterned by dry etching mainly using a chlorine-based gas with the resist pattern 19a as an etching mask to form a phase shift layer pattern.

Next, the absorption layer 14 was patterned by dry etching mainly using a chlorine-based gas to form the absorption layer pattern. Thus, the low reflective part pattern 18a including the phase shift layer pattern and the absorption layer pattern was formed.

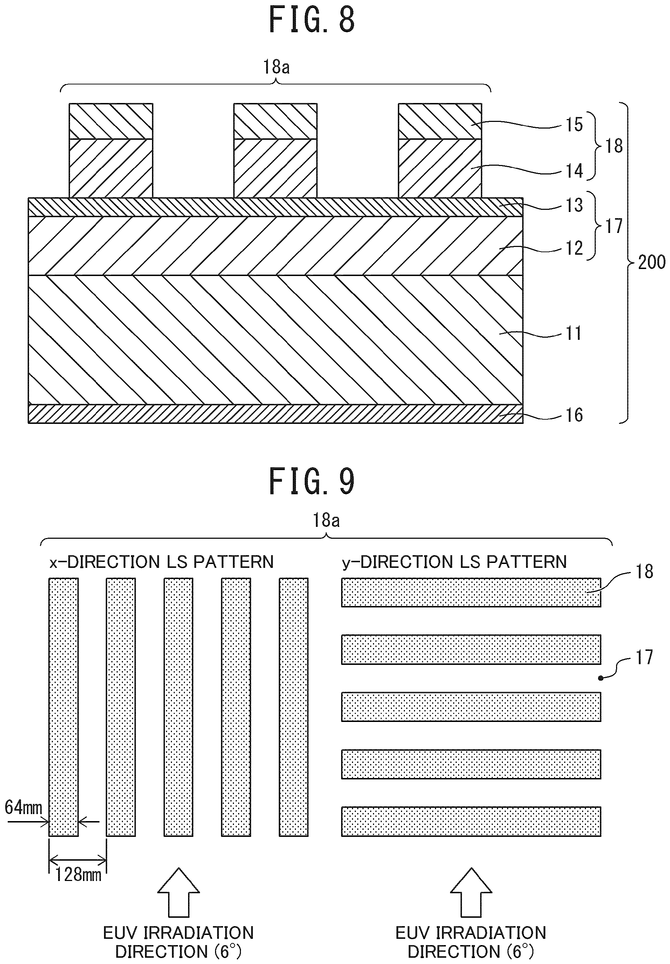

Next, the remaining resist pattern 19a was peeled off, thereby exposing the low reflective part pattern 18a. Thus, the reflective photomask 200 according to this embodiment was manufactured. The low reflective part pattern 18a formed in the low reflective part 18 contains an LS (line and space) pattern with a line width of 100 nm, an LS pattern with a line width of 200 nm for film thickness measurement of the absorption layer using AFM, and a 4 mm square low reflective part removed part for EUV reflectance measurement on the reflective photomask 200 for transfer evaluation. The LS pattern with a line width of 100 nm was designed in each of the x-direction and the y-direction as illustrated in FIG. 9 such that the influence of the shadowing effect by EUV oblique irradiation was able to be easily viewed. The low reflective part pattern of Example 1 contains an LS (line and space) pattern with a line width of 64 nm, an LS pattern with a line width of 200 nm for film thickness measurement of the absorption layer using AFM, and a 4 mm square low reflective part removed part for EUV reflectance measurement on the reflective photomask for transfer evaluation. The LS pattern with a line width of 64 nm was designed in each of the x-direction and the y-direction such that the influence of the shadowing effect by EUV oblique irradiation was able to be easily viewed.

### <Effects of this embodiment>

The reflective photomask blank 100 and the reflective photomask 200 according to this embodiment have the following effects.
(1) In the reflective photomask blank 100 of this embodiment, the absorption layer 14 and the phase shift layer 15 are deposited in this order on the reflective part 17.
   According to this configuration, the shadowing effect can be minimized, the effect of the phase shift can be exhibited, and high resolution can be obtained.
(2) In the reflective photomask blank 100 of this embodiment, the extinction coefficient k to the wavelength of 13.5 nm of the absorption layer 14 is k > 0.04.
   According to this configuration, the low reflective part 18 can be made thinner and the shadowing effect can be reduced by the use of the material having higher absorptivity to the EUV light than that of conventional materials.
(3) The optical constant to the wavelength of 13.5 nm of the material constituting the phase shift layer 15 in the reflective photomask blank 100 of this embodiment satisfies the refractive index n < 0.94 and the extinction coefficient k < 0.02.

According to this configuration, the phase difference can be easily adjusted by the film thickness and the shadowing effect can be reduced.

### EXAMPLES

Hereinafter, the present disclosure is described in more detail with respect to Examples but the present disclosure is not limited by Examples at all.

### <Example 1>

A synthetic quartz substrate having low thermal expansion properties was used as a substrate. On the substrate, a multi-layer reflective film was formed by depositing 40 multi-layer films each containing a pair of silicon (Si) and molybdenum (Mo). The film thickness of the multi-layer reflective film was set to 280 nm.

Next, a capping layer having a film thickness of 3.5 nm was formed using ruthenium (Ru) on the multi-layer reflective film. Thus, a reflective part having the multi-layer reflective film and the capping layer was formed on the substrate.

On the capping layer, an absorption layer containing tin (Sn) and oxygen (O) was formed. The film thickness of the absorption layer was set to 17 nm. The atomic number ratio of tin (Sn) and oxygen (O) was 1:2.5 as measured by EDX (energy dispersive X-ray analysis). The measurement by an XRD (X-ray diffractometer) showed that the absorption layer was amorphous although crystallinity was slightly observed.

Next, a phase shift layer having a film thickness of 28 nm was formed using molybdenum (Mo) on the absorption layer. Thus, a 45 nm thick low reflective part in which the absorption layer and the phase shift layer were deposited in this order was formed on the reflective layer. A phase difference of the low reflective part to the reflective part was set to 180°.

Next, on the side on which the multi-layer reflective film was not formed of the substrate, a back surface conductive film having a film thickness of 100 nm was formed using chromium nitride (CrN). Thus, a reflective photomask blank was produced.

For the formation of each film on the substrate, a multi-source sputtering apparatus was used. The film thickness of each film was controlled by a sputtering time. The absorption layer was formed to have an O/Sn ratio of 2.5 by controlling the amount of oxygen introduced into a chamber during sputtering by a reactive sputtering method.

Next, a positive chemically amplified resist (SEBP9012: manufactured by Shin-Etsu Chemical Co., Ltd.) was formed by spin coating to have a film thickness of 120 nm on the low reflective part, and then baked at 110°C for 10 min to form a resist film.

Next, a predetermined pattern was drawn on the positive chemically amplified resist by an electron beam lithography machine (JBX3030: manufactured by JEOL).

Thereafter, prebaking treatment was performed at 110°C for 10 minutes, followed by spray development (SFG3000: manufactured by Sigma Meltec). Thus, a resist pattern was formed.

Next, the phase shift layer was patterned by dry etching mainly using a fluorine-based gas with the resist pattern as an etching mask.

Next, the absorption layer was patterned by dry etching mainly using a chlorine-based gas to form an absorption layer pattern. Thus, a low reflective part pattern in which the absorption layer pattern and a phase shift layer pattern were deposited in this order was formed in the low reflective part.

Next, the remaining resist pattern was peeled off. Thus, a reflective photomask of Example 1 was produced.

The deposit of the absorption layer and the phase shift layer (i.e., low reflective part) had a reflectance of 5% to the EUV light having a wavelength of 13.5 nm.

### <Example 2>

The reflectance of the deposit of the absorption layer and the phase shift layer was changed to 10%. To obtain the reflectance of 10%, the film thickness of the absorption layer was changed to 9 nm and the film thickness of the phase shift layer was changed to 36 nm. A reflective photomask of Example 2 was produced in the same manner as in Example 1, except for the above.

### <Example 3>

The reflectance of the deposit of the absorption layer and the phase shift layer was changed to 15%. To obtain the reflectance of 15%, the film thickness of the absorption layer was changed to 8 nm and the film thickness of the phase shift layer was changed to 37 nm. A reflective photomask of Example 3 was produced in the same manner as in Example 1, except for the above.

### <Example 4>

The materials of the absorption layer were changed to tellurium (Te) and oxygen (O). A reflective photomask of Example 4 was produced in the same manner as in Example 1, except for the above.

### <Example 5>

The materials of the absorption layer were changed to cobalt (Co) and oxygen (O). A reflective photomask of Example 5 was produced in the same manner as in Example 1, except for the above.

### <Example 6>

The materials of the absorption layer were changed to nickel (Ni) and oxygen (O). A reflective photomask of Example 6 was produced in the same manner as in Example 1, except for the above.

### <Example 7>

The materials of the absorption layer were changed to platinum (Pt). A reflective photomask of Example 7 was produced in the same manner as in Example 1, except for the above.

### <Example 8>

The materials of the absorption layer were changed to silver (Ag) and oxygen (O). A reflective photomask of Example 8 was produced in the same manner as in Example 1, except for the above.

### <Example 9>

The materials of the absorption layer were changed to indium (In) and oxygen (O). A reflective photomask of Example 9 was produced in the same manner as in Example 1, except for the above.

### <Example 10>

The materials of the absorption layer were changed to cupper (Cu) and oxygen (O). A reflective photomask of Example 10 was produced in the same manner as in Example 1, except for the above.

### <Example 11>

The materials of the absorption layer were changed to zinc (Zn) and oxygen (O). A reflective photomask of Example 11 was produced in the same manner as in Example 1, except for the above.

### <Example 12>

The materials of the absorption layer were changed to bismuth (Bi) and oxygen (O). A reflective photomask of Example 12 was produced in the same manner as in Example 1, except for the above.

### <Example 13>

The materials of the absorption layer were changed to iron (Fe) and oxygen (O). A reflective photomask of Example 13 was produced in the same manner as in Example 1, except for the above.

### <Example 14>

The materials of the absorption layer were changed to carbon (C). A reflective photomask of Example 14 was produced in the same manner as in Example 1, except for the above.

### <Example 15>

The phase difference of the low reflective part to the reflective part was set to 155°. A reflective photomask of Example 15 was produced in the same manner as in Example 1, except for the above.

### <Example 16>

The reflectance of the deposit of the absorption layer and the phase shift layer was changed to 35%. A reflective photomask of Example 16 was produced in the same manner as in Example 1, except for the above.

### <Comparative Example 1>

In the production of a reflective photomask blank, a phase shift layer having a film thickness of 24 nm was formed using molybdenum (Mo) on a capping layer. Next, an absorption layer containing tin (Sn) and oxygen (O) was formed on a phase shift layer. The film thickness of the absorption layer was set to 21 nm. More specifically, a 45 nm thick low reflective part in which the phase shift layer and the absorption layer were deposited in this order was formed on a reflective layer.

In the production of a reflective photomask, after the formation of a resist pattern, the absorption layer was patterned by dry etching mainly using a chlorine-based gas with the resist pattern as an etching mask to form an absorption layer pattern.

Next, the phase shift layer was patterned by dry etching mainly using a fluorine-based gas. More specifically, a low reflective part pattern in which a phase shift layer pattern and the absorption layer pattern were deposited in this order was formed in the low reflective part. A reflective photomask of Comparative Example 1 was produced in the same manner as in Example 1, except for the above.

### <Evaluation>

The influence of the shadowing effect and the transfer performance were evaluated by the following methods for the reflective photomasks obtained in Examples 1 to 16, Comparative Example 1 described above. The transfer performance was confirmed by a wafer exposure evaluation.

### [Influence of shadowing effect]

In Examples 1 to 16 and Comparative Example 1, the Normalized Image Log Slope (NILS) value which is a characteristic value indicating the gradient between a bright part and a dark part was calculated from a light intensity distribution of a transfer pattern. When the NILS value is larger, the influence of the shadowing effect can be further reduced.

### [Wafer exposure evaluation]

The absorption layer pattern of the reflective photomask produced in each of Examples and Comparative Example was transferred and exposed onto a semiconductor wafer coated with an EUV positive chemically amplified resist using an EUV exposure apparatus (NXE3300B: manufactured by ASML). At this time, the exposure amount was adjusted such that the x-direction LS pattern was transferred as designed. Thereafter, the observation and the line width measurement of the transferred resist pattern were carried out by an electron beam dimension measuring machine, and the resolution and the H-V bias were confirmed.

Table 1 shows the evaluation results above.

**[Table 1]**

| | Reflective part | | | Phase difference of low reflective part to reflective part (°) | Evaluation results | |
|---|---|---|---|---|---|---|
| | Upper layer (Material) | Lower layer (Material) | Reflectance (%) | | NILS | H-V |
| Ex. 1 | Mo | Sn + O | 5 | 180 | 1.45 | 6.7 |
| Ex. 2 | Mo | Sn + O | 10 | 180 | 1.42 | 4.4 |
| Ex. 3 | Mo | Sn + O | 15 | 180 | 1.40 | 3.9 |
| Ex. 4 | Mo | Te + O | 5 | 180 | 1.44 | 6.0 |
| Ex. 5 | Mo | Co + O | 5 | 180 | 1.46 | 5.3 |
| Ex. 6 | Mo | Ni + O | 5 | 180 | 1.44 | 5.8 |
| Ex. 7 | Mo | Pt | 5 | 180 | 1.46 | 5.3 |
| Ex. 8 | Mo | Ac + O | 5 | 180 | 1.42 | 5.6 |
| Ex. 9 | Mo | In + O | 5 | 180 | 1.43 | 5.9 |
| Ex. 10 | Mo | Cu + O | 5 | 180 | 1.44 | 6.4 |
| Ex. 11 | Mo | Zn + O | 5 | 180 | 1.43 | 6.7 |
| Ex. 12 | Mo | Bi + O | 5 | 180 | 1.43 | 6.3 |
| Ex. 13 | Mo | Fe + O | 5 | 180 | 1.45 | 5.5 |
| Ex. 14 | C | Sn + O | 5 | 180 | 1.37 | 8.0 |
| Ex. 15 | Mo | Sn + O | 5 | 155 | 1.30 | 7.2 |
| Ex. 16 | Mo | Sn + O | 35 | 180 | 1.23 | 0.8 |
| Comp. Ex. 1 | Sn+O | Mo | 5 | 180 | 1.45 | 8.4 |

As shown in Table 1, it was found from the evaluation results of Examples 1 to 16, Comparative Example 1 that, when the absorption layer and the phase shift layer are deposited in this order on the reflective part as in Examples to 16, the influence of the shadowing effect can be further reduced, and thus the transferability is more excellent as compared with the case where the phase shift layer and the absorption layer are deposited in this order on the reflective part as in Comparative Example 1. In particular, it was revealed that the reflective photomasks of Example 1 to Example 16 each have a smaller H-V bias value and higher transferability as compared with those of the reflective photomask of Comparative Example 1.

The reflective photomask blank and the reflective photomask of the present disclosure are not limited to the embodiment and examples described above, and can be variously altered insofar as the features of the invention are not impaired.

### Reference Signs List

- 11: substrate
- 12: multi-layer reflective film
- 13: capping layer
- 14: absorption layer
- 15: phase shift layer
- 16: back surface conductive film
- 17: reflective part
- 18: low reflective part
- 18a: low reflective part pattern
- 19: resist film
- 19a: resist pattern
- 100: reflective photomask blank
- 200: reflective photomask

## Claims

1. A reflective photomask blank for producing a reflective photomask for pattern transfer using an extreme ultraviolet light as a light source comprising:
a substrate;
a reflective part formed on the substrate and configured to reflect an incident light; and
a low reflective part formed on the reflective part and configured to absorb an incident light, wherein
the low reflective part is a multi-layer structural body having at least two or more layers including an absorption layer and a phase shift layer,
the absorption layer and the phase shift layer are deposited in this order on the reflective part,
an optical constant to a wavelength of 13.5 nm of a material constituting the absorption layer satisfies an extinction coefficient k > 0.041, and
the optical constant to the wavelength of 13.5 nm of a material constituting the phase shift layer satisfies a refractive index n < 0.94 and the extinction coefficient k < 0.02.

2. The reflective photomask blank according to claim 1, wherein the absorption layer contains a total of 50 at% or more of at least one kind of element selected from the group consisting of tellurium (Te), cobalt (Co), nickel (Ni), platinum (Pt), silver (Ag), tin (Sn), indium (In), copper (Cu), zinc (Zn), and bismuth (Bi), and oxides, nitrides, and oxynitrides of tellurium (Te), cobalt (Co), nickel (Ni), platinum (Pt), silver (Ag), tin (Sn), indium (In), copper (Cu), zinc (Zn), and bismuth (Bi) .

3. The reflective photomask blank according to claim 1 or 2, wherein the phase shift layer contains a total of 50 at% or more of at least one kind of atom or molecule elements selected from the group consisting of molybdenum (Mo), ruthenium (Ru), and niobium (Nb), and oxides, nitrides, and oxynitrides of molybdenum (Mo), ruthenium (Ru), and niobium (Nb).

4. The reflective photomask blank according to any one of claims 1 to 3, wherein the low reflective part including the absorption layer and the phase shift layer has a phase difference of 160 to 200° to the reflective part and a reflectance of 1% to 40% according to a film thickness ratio of the absorption layer and the phase shift layer.

5. A reflective photomask for pattern transfer using an extreme ultraviolet light as a light source comprising:
a substrate;
a reflective part formed on the substrate and configured to reflect an incident light; and
a low reflective part formed on the reflective part and configured to absorb an incident light, wherein
the low reflective part is a multi-layer structural body having at least two or more layers including an absorption layer and a phase shift layer,
the absorption layer and the phase shift layer are deposited in this order on the reflective part,
an optical constant to a wavelength of 13.5 nm of a material constituting the absorption layer satisfies an extinction coefficient k > 0.041, and
the optical constant to the wavelength of 13.5 nm of a material constituting the phase shift layer satisfies a refractive index n < 0.94 and the extinction coefficient k < 0.02.
